(19) Europäisches Patentamt
European Patent Office
Office européen des brevets

(11) EP 1 107 332 A2

(12) **EUROPEAN PATENT APPLICATION**

(43) Date of publication:
**13.06.2001 Bulletin 2001/24**

(51) Int Cl.[7]: **H01L 51/20**

(21) Application number: **00126988.5**

(22) Date of filing: **08.12.2000**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **10.12.1999 JP 35184299**

(71) Applicant: **FUJI PHOTO FILM CO., LTD.**
**Kanagawa-ken (JP)**

(72) Inventors:
- **Nakamura, Yoshisada, c/o Fuji Photo Film Co., Ltd. Minami Ashigara-shi, Kanagawa (JP)**
- **Kubota, Tadahiko, c/o Fuji Photo Film Co., Ltd. Minami Ashigara-shi, Kanagawa (JP)**

(74) Representative: **Grünecker, Kinkeldey, Stockmair & Schwanhäusser Anwaltssozietät**
**Maximilianstrasse 58**
**80538 München (DE)**

(54) **Photoelectric conversion device**

(57) A photoelectric conversion device comprising an electrically conductive support, a photosensitive layer containing semiconductor particles having a dye adsorbed thereby, a positive hole-transporting layer and a counter electrode, wherein said positive hole-transporting layer is one prepared by a method involving an electroless plating step.

*FIG. 1*

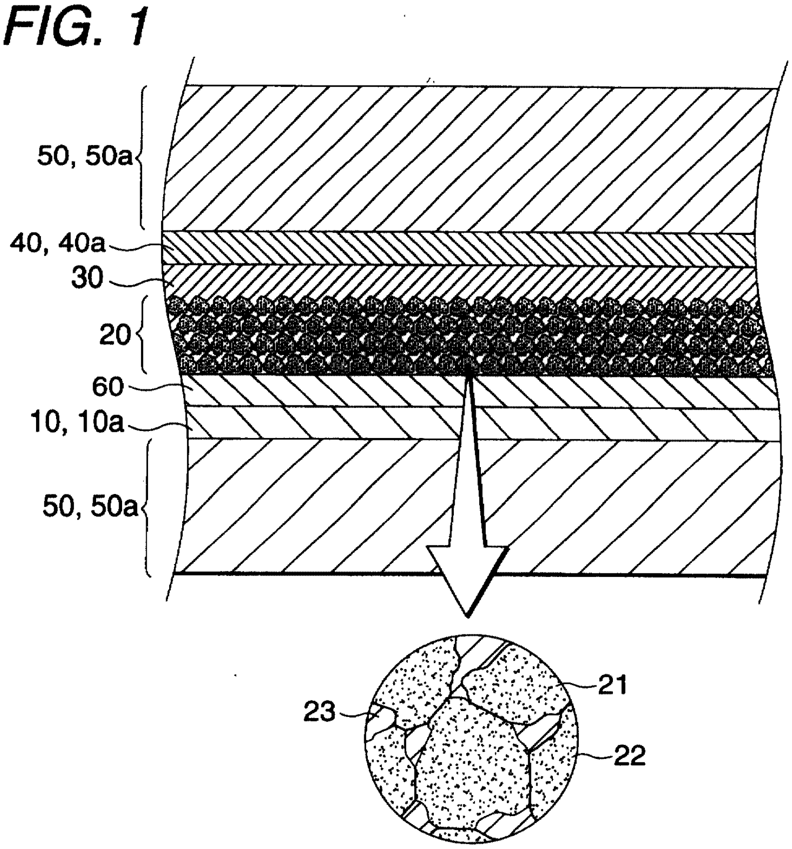


EP 1 107 332 A2

## Description

### FIELD OF THE INVENTION

The present invention relates to a photoelectric conversion device comprising semiconductor particles sensitized with a dye.

### BACKGROUND OF THE INVENTION

Solar power generation has been accomplished by the practical use of single crystal silicon solar cell, polycrystalline silicon solar cell, amorphous silicon solar cell and compound solar cell made of cadmium telluride or indium selenide. Solar power generation has been one of major researches and studies. However, in order to widely use these solar cells, it is necessary to overcome difficulties in production cost, availability of raw materials and reduction of energy pay back time. On the other hand, many solar cells comprising an organic material have been proposed aiming at the increase of area or reduction of cost. However, these proposals are disadvantageous in that they exhibit a low conversion efficiency and a deteriorated durability.

Under these circumstances, "Nature", vol. 353, pp. 737 - 740, 1991, and U.S. Patent 4,927,721 disclosed a photoelectric conversion device and solar cell comprising semiconductor particles sensitized with a dye, materials from which such a photoelectric conversion device is prepared, and a production technique for producing such a photoelectric conversion device. The cell thus proposed is a wet solar cell comprising as a working electrode a thin porous layer of titanium dioxide spectrally sensitized with a ruthenium complex. This system is firstly advantageous in that an inexpensive oxide semiconductor such as titanium dioxide can be used without being highly purified, making it possible to provide an inexpensive photoelectric conversion device. This system is secondly advantageous in that the dye used has a broad absorption, making it possible to convert almost the total wavelength range of visible light to electricity. However, since this photoelectric conversion device is a wet solar cell which makes electrical connection to the counter electrode with an electrolytic solution, it is apprehended that prolonged use can be followed by the exhaustion of the electrolytic solution that causes a drastic drop of photoelectric conversion efficiency or disables the element as a photocell. In order to prevent the exhaustion of electrolytic solution in wet solar cells with time, J. Phys. D: Appl. Phys. 31 (1998), pp. 1,492 - 1,496, and Chem. Mater. 1998, 10, pp. 1,501 - 1,509 propose a photoelectric conversion device solidified with an inorganic positive hole-transporting material such as CuI and CuSCN. However, studies show that these photoelectric conversion devices comprising such a positive hole-transporting material are disadvantageous in that they are liable to occurrence of shortcircuiting and hence drastic deterioration with time.

### SUMMARY OF THE INVENTION

An object of the present invention is to provide a photoelectric conversion device and photocell having a high conversion efficiency which are not liable to drop of conversion efficiency due to shortcircuiting or aging. Another object of the present invention is to provide a process for the production of a positive hole-transporting layer for such a photoelectric conversion device.

The objects of the present invention are accomplished by the following matters defining the present invention.

(1) A photoelectric conversion device comprising an electrically conductive support, a photosensitive layer containing semiconductor particles having a dye adsorbed thereby, a positive hole-transporting layer and a counter electrode, characterized in that the positive hole-transporting layer is one prepared by a method involving an electroless plating step.

(2) The photoelectric conversion device of item (1) above, wherein the method involving an electroless plating step comprises a plating step of effecting electroless metal plating and a post-step of converting the plating metal to a positive hole-transporting material.

(3) The photoelectric conversion device of item (2) above, wherein the positive hole-transporting material is at least one p-type compound semiconductor positive hole-transporting material.

(4) The photoelectric conversion device of item (3) above, wherein the p-type compound semiconductor is a compound semiconductor containing monovalent copper.

(5) The photoelectric conversion device of item (4) above, wherein the compound semiconductor containing monovalent copper comprises copper iodide and/or copper thiocyanate.

(6) A photocell comprising a photoelectric conversion device of any one of items (1) to (5).

(7) A photocell module formed by a photoelectric conversion device of any one of items (1) to (5).

(8) A process for the production of a positive hole-transporting layer for a photoelectric conversion device by a method involving an electroless plating step.

BRIEF DESCRIPTION OF THE DRAWINGS

Fig. 1 is a partial sectional view illustrating the structure of a preferred embodiment of the photoelectric conversion device according to the invention.
Fig. 2 is a partial sectional view illustrating the structure of another preferred embodiment of the photoelectric conversion device according to the invention.
Fig. 3 is a partial sectional view illustrating the structure of a still other preferred embodiment of the photoelectric conversion device according to the invention.
Fig. 4 is a partial sectional view illustrating the structure of a still other preferred embodiment of the photoelectric conversion device according to the invention.
Fig. 5 is a partial sectional view illustrating the structure of a still other preferred embodiment of the photoelectric conversion device according to the invention.
Fig. 6 is a partial sectional view illustrating the structure of a still other preferred embodiment of the photoelectric conversion device according to the invention.
Fig. 7 is a partial sectional view illustrating the structure of a still other preferred embodiment of the photoelectric conversion device according to the invention.
Fig. 8 is a partial sectional view illustrating the structure of a still other preferred embodiment of the photoelectric conversion device according to the invention.
Fig. 9 is a partial sectional view illustrating the structure of a still other preferred embodiment of the photoelectric conversion device according to the invention.
Fig. 10 is a partial sectional view illustrating an embodiment of the structure of a substrate-integrated photocell module comprising a photoelectric conversion device according to the invention.

DETAILED DESCRIPTION OF THE INVENTION

[1] Photoelectric conversion device

The photoelectric conversion device according to the invention comprises a p-type compound semiconductor incorporated in a positive hole-transporting layer. The photoelectric conversion device according to the invention preferably comprises an electrically-conductive layer 10, an undercoat layer 60, a photosensitive layer 20, a positive hole-transporting layer 30, and a counter electrode electrically-conductive layer 40 laminated in this order, in which the photosenstive layer 20 is formed by semiconductor particles 21 sensitized with a dye 22 and a positive hole-transporting material 23 present in the gap between the semiconductor particles 21, as shown in Fig. 1. The positive hole-transporting material 23 is made of the same material as used for the positive hole-transporting layer 30. In order to provide the photoelectric conversion device with a sufficient strength, the photoelectric conversion device may comprise a substrate 50 provided on the electrically-conductive layer 10 side and/or the counter electrode electrically-conductive layer 40 side thereof. The layer consisting of the electrically-conductive layer 10 and the arbitrarily provided substrate 50 will be hereinafter referred to as "electrically conductive support". The layer consisting of the counter electrode electrically-conductive layer 40 and the arbitrarily provided substrate 50 will be hereinafter referred to as "counter electrode". An apparatus which comprises such a photoelectric conversion device connected to an external circuit so that it works is called solar photocell. The electrically-conductive layer 10, the counter electrode electrically-conductive layer 40 and the substrate 50 in Fig. 1 may be a transparent electrically-conductor layer 10a, a transparent counter electrode electrically-conductive layer 40a and a transparent substrate 50a, respectively.
In the photoelectric conversion device of the invention shown in Fig. 1, light which is incident upon the photosensitive layer 20 comprising the semiconductor particles 21 sensitized with the dye 22 excites the dye 22 or the like. High energy electrons in the dye 22 or the like thus excited are then transferred to the conduction band in the semiconductor particles 21. These electrons then diffuse to the electrically-conductive layer 10. At this point, the molecule of the dye 22 or the like is in the form of oxide. In a solar photocell, electrons in the electrically-conductive layer 10 are passed to the external circuit where they work, and then returned to the oxide of dye 22 or the like through the counter electrode electrically-conductive layer 40 and the positive hole-transporting layer 30 to regenerate the dye 22. The photosensitive layer 20 works as a negative electrode. At the border of the various layers (e.g., border of the electrically-conductive layer 10 with the photosensitive layer 20, border of the photosensitive layer 20 with the positive hole-transporting layer 30, border of the positive hole-transporting layer 30 with the counter electrode electrically-conductive layer 40), the constituents of these layers may diffuse into each other. The various layers will be further described hereinafter.

(A) Positive hole-transporting layer

The positive hole-transporting layer of the invention acts to rapidly reduce the oxide of dye and transport positive holes injected at the interface of the dye to the counter electrode. The positive hole-transporting layer of the invention comprises a positive hole-transporting material. Such a positive hole-transporting material preferably comprises a p-type inorganic compound semiconductor as a main component. Two or more positive hole-transporting materials may be used in combination. The positive hole-transporting material may be used in combination with an electrolyte (particularly molten salt electrolyte). Preferred examples of inorganic p-type semiconductors include compound semiconductor containing monovalent copper, GaP, NiO, CoO, FeO, $Bi_2O_3$, $MoO_2$, and $Cr_2O_3$. Particularly preferred among these semiconductors is compound semiconductor containing monovalent copper.

Examples of compound semiconductor containing monovalent copper which can be preferably used in the invention include CUI, CuSCN, $CuInSe_2$, $Cu(In,Ga)Se_2$, $CuGaSe_2$, $Cu_2O$, CuS, $CuGaS_2$,$CuInS_2$ and $CuAlSe_2$. Preferred among these compound semiconductors are copper iodide (CuI), and copper thiocyanate (CuSCN). Mostly preferred among these compound semiconductors is CuI (particularly $\gamma$-CuI). The band gap of the compound semiconductor containing monovalent copper is preferably great to avoid the prevention of absorption of light by dyes. The band gap of the p-type compound semiconductor to be used in the invention is preferably 2 eV or more, more preferably 2.5 eV or more. It is also necessary that the ionization potential of the p-type compound semiconductor be smaller than that of the dye-adsorbed electrode to reduce the dye hole. The preferred range of ionization potential of the p-type compound semiconductor to be used in the positive hole-transporting layer depends on the dye to be used in the photoelectric conversion device of the invention. In practice, however, it is preferably from 4.5 eV to less than 5.5 eV, more preferably from 4.7 eV to less than 5.3 eV. The mobility of hole in the positive hole-transporting layer containing a p-type compound semiconductor of the invention is preferably from $10^{-4}$ $cm^2/V \cdot sec$ to less than $10^4$ $cm^2/V \cdot sec$, more preferably $10^{-3}$ $cm^2/V \cdot sec$ to less than $10^3$ $cm^2/V \cdot sec$. The electrical conductivity of the positive hole-transporting layer of the invention is preferably from $10^{-8}$ S/cm to less than $10^2$ S/cm, more preferably from $10^{-6}$ S/cm to less than 10 S/cm.

If necessary, the positive hole-transporting layer of the invention may be subjected to acceptor doping to enhance the carrier density or electrical conductivity thereof. Examples of compounds which may be preferably used as dopant of the invention include iodine, tris(4-bromophenyl)aminium hexachloroantimonate, $NOPF_6$, $SbCl_5$, $I_2$, $Br_2$, $HClO_4$, $(n\text{-}C_4H_9)_4ClO_4$, trifluoroacetic acid, 4-dodecylbenzenesulfonic acid, 1-naphthalenesulfonic acid, $FeCl_3$, $AuCl_3$, $NOSbF_6$, $AsF_5$, $NOBF_4$, $LiBF_4$, $H_3[PMO_{12}O_{40}]$, 7, 7, 8, 8-tetracyanoquinodimethane (TCNQ), and Fullerene C60. However, the present invention is not limited to these compounds. The amount of such a dopant, if added, is preferably from 0.0001% by weight to less than 5% by weight, more preferably from 0.001% by weight to less than 3% by weight based on the weight of the compound semiconductor.

The thickness of the positive hole-transporting layer of the invention on the layer containing semiconductor particles having a dye adsorbed thereto is preferably from 0.005 $\mu$m to less than 100 $\mu$m, more preferably from 0.01 $\mu$m to less than 70 $\mu$m, particularly from 0.05 $\mu$m to less than 50 $\mu$m.

The method for the formation of the p-type compound semiconductor which is preferably used in the invention will be described hereinafter. The positive hole-transporting layer of the invention is prepared by a method involving an electroless plating step. In the invention, at least one electroless plating step may be involved. Examples of the foregoing method for the formation of the p-type compound semiconductor employable herein include reduction method involving two steps and oxidation method involving one step.

(1) Reduction method

The reduction method consists of an "electroless plating step" for normally electrolessly plating a dye-adsorbed semiconductor particle layer with a metal and a "post-step" for converting the plating metal to p-type inorganic compound semiconductor. The plating step may be carried out by an electroless plating method as described in "Mudenkai Mekki (Electroless Plating) (Kinzoku Hyoumen Gijutu Koza Vol. 9)", Compiled by Association of Metal Surface Technique, Asakura Shoten, 1971, "Saishin Gijutu Guide Book (Guide Book of Modern Technology)", Sogo Gijutu Center, 1986, "Mekki Gijtu Guide Book (Guide Book of Plating Technique)", Tokyo Tokin Zairyo Kyodo Kumiai, 1987, Ken Masumoto and Toru Watanabe, "Amorphous Mekki Ho to Sono Ouyou (Amorphous Plating Method and Its Application", Nikkan Kogyo Shinbunsha, 1990, and Toshiro Okamura, "Mudenkai Mekki no Ouyou (Application of Electroless Plating)", Maki Shoten, 1991.

Unlike electroplating, electroless plating requires no supply of electricity. In electroless plating, metallic cations are reduced with a reducing agent present in the plating solution so that the resulting metal is deposited on the surface to be plated. The plating solution to be used in the plating step comprises a metal salt, a reducing agent, and additives. As such a metal salt there may be used a sulfate, acetate, carbonate or the like. In the case of copper plating, copper sulfate, copper acetate or copper carbonate is preferably used. Particularly preferred among these copper salts is copper sulfate. As the reducing agent there may be used hypophosphite (e.g., sodium hypophosphite), borohydride

(e.g., sodium borohydride), hydrazine, formaldehyde (HCHO), dimethylamine boran ($(CH_3)_2NHBH_3$) or the like. The preferred reducing agent depends on the plating metal. In the case of copper plating, formaldehyde or dimethylamine boran, which undergoes catalytic oxidation on the copperplated surface, is preferably used. In the case of nickel plating, sodium hypophosphite, sodium borohydride or hydrazine is preferably used.

Preferred examples of the additives employable herein include base for changing the pH value of the reaction solution toward basic conditions, buffer for inhibiting the drop of pH in the reaction process, stabilizer for preventing the precipitation of metal in the solution, surface active agent for accelerating the removal of hydrogen gas produced in the reaction solution, and wetting agent.

As the base there is preferably used an inorganic base. Preferred among these inorganic bases is sodium hydroxide. As the buffer there may be used an organic or inorganic acid salt. As the stabilizer there is preferably used one capable of forming a metal complex such as EDTA, bipyridyl, thiourea, MBT and cyan compound. As the wetting agent there is preferably used PEG (polyethylene glycol) or the like.

The electroless plating is preferably preceded by a previous step such as solvent treatment, etching, provision of catalyst and acceleration of activity for the purpose of improving its adhesivity. Among these previous steps, solvent treatment and etching are intended to clean the surface of the object to be plated as well as to roughen somewhat the surface of the object, giving an anchoring effect that enhances adhesivity.

As the detergent to be used for the semiconductor particles there may be used a polar solvent such as weak aqueous alkali, alcohol and acetonitrile. For etching, an acid such as nitric acid and hydrofluoric acid is preferably used. The provision of catalyst and acceleration of activity are effected to provide a surface on which a metal can inherently be hardly deposited with a site having a catalytic function for accelerating the deposition of a metal. Preferred examples of these steps include catalyst (Pd colloid, e.g., $Pd^{2+}/Sn^{2+}$ hydrochloric acid solution)→accelerator (acid, e.g., sulfuric acid solution) process, sensitizer (e.g., tin chloride hydrochloric acid solution)→activator (e.g., palladium chloride hydrochloric acid solution) process, alkali ion catalyst process, and heat treatment process (preceded by the immersion in an organic complex solvent of Pd or Ag).

Examples of the post-step for converting the plating metal to a p-type inorganic compound semiconductor include step for converting the plating metal, if it is copper, to copper iodide, copper thiocyanate, etc. The step for converting to copper iodide is preferably carried out by a method involving aging in an iodine vapor or a method involving the immersion in a potassium iodide solution.

(2) Oxidation method

The oxidation method may involve the direct precipitation of copper iodide from a solution containing $CuI_2$ anion and/or $CuI_3$ anion in the presence of an oxidizing agent. The oxidizing agent preferably has an oxidation potential of higher than + 0.25 V (vs Ag/AgCl).

(B) Electrically conductive support

The electrically conductive support consists of (1) a single electrically-conductive layer or (2) two layers, i.e., electrically-conductive layer and substrate. If an electrically-conductive layer which can sufficiently maintain strength and sealing properties is used, a substrate is not necessarily required.

In the case of the structure (1), the electrically-conductive layer is made of a material having a sufficient strength and an electrical conductivity such as metal.

In the case of the structure (2), a substrate having an electrically-conductive layer comprising an electrically-conducting agent -incorporated therein on the photosensitive layer side thereof may be used. Preferred examples of the electrically-conducting agent include metal (e.g., platinum, gold, silver, copper, aluminum, rhodium, indium), carbon, and electrically-conductive metal oxide (e.g., indium-tin composite oxide, tin oxide doped with fluorine). The thickness of the electrically-conductive layer is preferably from about 0.02 μm to 10 μm.

The surface resistivity of the electrically-conductive layer is preferably as low as possible. The surface resistivity of the electrically-conductive layer is preferably 100 Ω/square or less, more preferably 40 Ω/square or less. The lower limit of the surface resistivity of the electrically-conductive layer is not specifically limited. In practice, however, it is about 0.1 Ω/square.

If the photoelectric conversion device of the invention is irradiated with light on the electrically conductive support side thereof, the electrically conductive support is preferably substantially transparent. The term "substantially transparent" as used herein is meant to indicate that light transmittance is 10% or more, preferably 50% or more, particularly 70% or more.

The transparent electrically conductive support preferably comprises a transparent substrate such as glass and plastics having a transparent electrically-conductive layer made of an electrically-conductive metal oxide coated or vacuum-evaporated thereon. In particular, an electrically-conductive glass having an electrically-conductive layer

made of tin dioxide doped with fluorine deposited on a transparent support made of inexpensive soda-lime float glass is preferred. In order to provide a flexible photoelectric conversion device or solar photocell at a low cost, a transparent electrically conductive support having an electrically-conductive layer provided on a transparent polymer film is preferably used. Examples of the material constituting the transparent polymer include tetraacetyl cellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyestersulfone (PES), polyetherimide (PEI), cyclic polyolefin, and bromated phenoxy. In order to secure sufficient transparency, the amount of the electrically-conductive metal oxide to be applied is preferably from 0.01 to 100 g per $m^2$ of glass or plastic support.

For the purpose of lowering the resistivity of the transparent electrically conductive support, a metal lead is preferably used. The metal lead is preferably made of a metal such as aluminum, copper, silver, gold, platinum and nickel, particularly aluminum or silver. The metal lead is preferably provided by vacuum-evaporating or sputtering a metal onto a transparent substrate. A transparent electrically-conductive layer made of tin oxide or ITO film doped with fluorine is then formed on the metal lead. It is also preferred that a metal lead be provided on a transparent electrically-conductive layer formed on a transparent substrate. The drop of the amount of incident light due to the provision of metal lead is preferably 10% or less, more preferably from 1% to 5%.

(C) Undercoat layer

In the present invention, it is preferred that a thin dense oxide semiconductor layer be previously provided on the electrically conductive support as an undercoat layer to prevent shortcircuiting between the counter electrode and the electrically conductive support. The oxide semiconductor which is preferably used as an undercoat layer has the same meaning as the semiconductor described with reference to the semiconductor particles in the clause (D) (1) later. The oxide semiconductor is preferably of the same type as the semiconductor in the photosensitive layer. Specific preferred examples of the semiconductor include $TiO_2$, ZnO, $SnO_2$, $Fe_2O_3$, $WO_3$, and $Nb_2O_5$. Particularly preferred among these compounds is $TiO_2$.

The undercoat layer may be formed by a coating method, spray pyrolysis method, vacuum evaporation method, sputtering method, casting method, spin coating method, dipping method or electroplating method. Preferred among these methods are coating method and spray pyrolysis method. Particularly preferred among these methods is spray pyrolysis method. If the coating method is used, a coating solution having a binder resin which can difficultly trap positive holes and additives such as leveling agent and coating property improver (e.g., surface active agent) is prepared as necessary. The coating solution thus prepared can be then applied by spin coating method, dip coating method, air knife coating method, curtain coating method, roller coating method, wire bar coating method, gravure coating method or extrusion coating method using a hopper described in U.S. Patent 2,681,294 to form a positive hole-transporting layer.

If the spray pyrolysis method is used to provide a $TiO_2$ undercoat layer, a titanium compound solution may be atomist-sprayed onto an electrically conductive support which has been heated to provide an undercoat layer. For the details of this coating method, reference can be made to Electrochimica Acta, vol. 140, No. 5, pp. 643 - 652 (1995). Preferred examples of the titanium compound employable herein include titanium tetraethoxide, titanium tetraisopropoxide, titanium tetrabutoxide, titanium acetylacetonate, di-isopropoxytitanium bisacetylacetonate, and titanium tetrachloride. Preferred among these titanium compounds are titanium tetraisopropoxide, titanium acetylacetonate, and di-isopropoxytitanium bisacetylactonate. Particularly preferred among these titanium compounds is titanium tetraisopropoxide. Such a titanium compound may be used in combination with a solvent capable of dissolving it therein. Preferred examples of such a solvent include methanol, ethanol, isopropanol, and acetylacetone. Particularly preferred among these solvents include ethanol, isopropanol, and acetylacetone. These solvents may be used in admixture. The concentration of titanium compound is preferably from 0.01 mol/l to 5 mol/l, more preferably from 0.05 mol/l to 2 mol/l, particularly from 0.05 mol/l to 1 mol/l. The temperature at which the electrically conductive support is heated is preferably from 200°C to 600°C, more preferably from 300°C to 600°C, particularly from 350°C to 500°C.

The thickness of the undercoat layer is preferably from 5 nm to 1,000 nm, more preferably from 10 nm to 500 nm.

(D) Photosensitive layer

In the photosensitive layer containing semiconductor particles, the semiconductor acts as a so-called photoreceptor which absorbs light to cause separation of electric charge and hence produce electron and positive hole. In the dye-sensitized semiconductor particles, the absorption of light and the resulting production of electron and positive hole occur mainly in the dye. The semiconductor particles accept and transfer the electron. The semiconductor to be incorporated in the photosensitive layer of the invention is preferably an n-type semiconductor which allows conduction electron to become a carrier that gives an anode current when excited with light.

(1) Semiconductor particles

Examples of the semiconductor particles employable herein include single semiconductor such as silicon and germanium, semiconductor of compound of the groups III to V, metal chalcogenide (e.g., oxide, sulfide, selenide), and compound having perovskite structure (e.g., strontium titanate, calcium titanate, sodium titanate, barium titanate, potassium niobate).

Preferred examples of metal chalcogenide include oxide of titanium, tin, zinc, iron, tungsten, zirconium, hafnium, strontium, indium, cerium, yttrium, lanthanum, vanadium, niobium and tantalum, sulfide of cadmium, zinc, lead, silver, antimony and bismuth, selenide of cadmium and lead, and telluride of cadmium. Other examples of compound semiconductor include phosphide of zinc, gallium, indium and cadmium, selenide of gallium-arsenic and copper-indium, and sulfide of copper-indium.

Specific preferred examples of the semiconductor to be used in the invention include Si, $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$, and $CuInSe_2$. Preferred among these semiconductors are $TiO_2$, ZnO, $SnO_2$, $Fe_2O_3$, $WO_3$, $Nb_2O_5$, CdS, PbS, CdSe, InP, GaAs, $CuInS_2$, and $CuInSe_2$. Particularly preferred among these semiconductors are $TiO_2$ and $Nb_2O_5$. Mostly preferred among these semiconductors is $TiO_2$.

The semiconductor to be used in the invention may be a single crystal or polycrystal. From the standpoint of conversion efficiency, the semiconductor is preferably a single crystal. However, from the standpoint of product cost, availability of raw material, energy payback time, etc., the semiconductor is preferably a polycrystal. In particular, a porous semiconductor membrane comprising semiconductor particles is preferred.

The particle diameter of the semiconductor particles is normally on the order of nm to μm. The average diameter of primary particles is preferably from 5 nm to 200 nm, more preferably from 8 nm to 100 nm as determined from diameter calculated in terms of circle converted from projected area. The average diameter of semiconductor particles (secondary particles) in the dispersion is preferably from 0.01 μm to 100 μm.

Two or more kinds of semiconductor particles having different particle diameter distributions may be used in admixture. In this case, the average size of the semiconductor particles having smaller size is preferably 5 nm or less. For the purpose of scattering incident light to enhance the trapping rate of light, semiconductor particles having a particle diameter as great as about 300 nm may be used as well.

Preferred examples of the method for the production of the semiconductor particles include sol-gel method described in Sumio Sakubana, "Sol-Gel Ho no Kagaku (Science of Sol-Gel Method)", Agne Shofu-sha, 1998, "Sol-Gel Ho ni yoru Hakumaku Coating Gijutu (Thin Film Coating Technique by Sol-Gel Method)", Gijutu Joho Kyokai, and gel-sol method described in Tadao Sugimoto, "Shingoseiho Gel-Sol Ho niyoru Tanbunsan Ryushi no Gosei to Saizu Keitai Seigyo (Synthesis of monodisperse particles and size and form control by new synthesis gel-sol method)", Materia, vol. 35, No. 9, pp. 1,012 - 1,018, 1996. Alternatively, a method involving the preparation of an oxide by high temperature hydrolysis of a chloride in an oxyhydrogen salt developed by Degussa Inc. is preferably used.

If the semiconductor particles are titanium oxide, any of the foregoing sol-gel method, gel-sol method, and method involving high temperature hydrolysis of a chloride in an oxyhydrogen salt is preferred. Further, sulfuric acid method and chlorine method described in Manabu Seino, "Sanka Titan Bussei to Ouyou Gijutu (Titanium oxide-Its Physical properties and applied technique)", Gihodo, 1997, may be used. Preferred examples of the sol-gel method employable herein include a method described in Barb et al., "Journal of American Ceramic Society", vol. 80, No. 12, pp. 3,157 - 3,171, 1997, and a method described in Barnside et al., "Chemistry of Materials", vol. 10, No. 9, pp. 2,419 - 2,425.

Titanium oxide is mainly divided into two crystal types, i.e., anatase type and rutile type. Either of the two types may be used depending on their production method and heat history. The two crystal types may be often used in admixture. Titanium oxide of the invention preferably has a high anatase content. The high anatase content of titanium oxide of the invention is more preferably 80% or more. The absorption band of anatase titanium oxide has a shorter wavelength at a longer end thereof than that of rutile titanium oxide. Thus, anatase titanium oxide is less liable to damage of photoelectric conversion device by ultraviolet rays than rutile titanium oxide. The anatase content can be determined by x-ray diffractometry. In some detail, the anatase content can be determined from the ratio of diffraction peak intensity derived from anatase titanium oxide and rutile titanium oxide.

(2) Semiconductor particles layer

In order to apply the semiconductor particles to the electrically conductive support, a method may be used which comprises applying a dispersion or colloid solution of semiconductor particles to an electrically conductive support. Alternatively, the foregoing sol-gel method or the like may be used. Taking into account the mass producibility of photoelectric conversion device, physical properties of semiconductor particle liquids, flexibility of electrically conductive support, etc., wet film-forming method is relatively advantageous. Representative examples of wet film-forming

method include coating method, and printing method.

Examples of the method for the preparation of a dispersion of semiconductor particles include the foregoing sol-gel method, method which comprises crushing semiconductor in a mortar, method which comprises crushing semiconductor during dispersion, and method which comprises allowing the precipitation of semiconductor particles in a solvent during its synthesis, and then using it as it is.

Examples of the dispersion medium to be used herein include water and various organic solvents (e.g., methanol, ethanol, isopropyl alcohol, dichloromethane, acetone, acetonitrile, ethyl acetate). During dispersion, a polymer such as polyethylene glycol, a surface active agent, an acid, a chelating agent or the like may be used as a dispersing aid as necessary. A polyethylene glycol is preferably added because the molecular weight of the polyethylene glycol can be changed to form a film which can hardly be peeled off or adjust the viscosity of the dispersion.

Preferred examples of the coating method employable herein include application-based method such as roller method and dip method, metering-based method such as air knife method and blade method, and method allowing application-based method and metering-based method at the same area, such as wire bar method disclosed in JP-B-58-4589 (The term "JP-B" as used herein means an "examined Japanese patent application") and slide hopper method, extrusion method and curtain method described in U.S. Patents 2,681,294, 2,761,419 and 2,761,791. As a method using a general-purpose machine there is preferably used spin method or spray method. Preferred examples of the wet printing method employable herein include three major printing methods, i.e., letterpress printing, offset printing and gravure printing, intaglio printing, rubber plate printing and screen printing. A preferred film-forming method is selected from these methods depending on the liquid viscosity and wet thickness.

The viscosity of the dispersion of semiconductor particles depends greatly on the kind and dispersibility of the semiconductor particles, the kind of the solvent used, and additives such as surface active agent and binder. When a solution having a viscosity as high as from 0.01 to 500 Poise is used, extrusion method, casting method, screen printing method, etc. may be used. When a solution having a viscosity as low as 0.1 Poise or less is used, slide hopper method, wire bar method or spin method is preferred. These methods can form a uniform film. If a certain amount of solution can be applied, extrusion method can be applied even to a low viscosity solution. Thus, wet film-forming method may be properly selected depending on the viscosity of the coating solution, the applied amount of the coating solution, the kind of the support, the coating speed, etc.

The semiconductor particles layer may not necessarily consist of a single layer but may be formed by applying a plurality of dispersions of semiconductor particles having different particle diameters or coat layers containing different semiconductor particles (or different binders or additives). Even if the thickness of a layer attained by one coating is insufficient, the multi-layer coating method can work well. The multi-layer coating is preferably accomplished by extrusion method or slide hopper method. In the case where multi-layer coating is effected, a plurality of layers may be applied at the same time. Alternatively, a plurality of layers may be applied in sequence. If sequential multi-layer coating is effected, screen printing method is preferably employed.

In general, the more the thickness of the semiconductor particles layer (the same as the thickness of the photosensitive layer) is, the more is the amount of dye supported per unit projected area and the higher is the trapping rate of light, but the more is the diffusion distance of the resulting electrons and the greater is the loss due to recombination of electric charge. Accordingly, the thickness of the semiconductor particles layer is preferably from 0.1 μm to 100 μm. The thickness of the semiconductor particles layer, if used in solar photocell, is preferably from 1 μm to 30 μm, more preferably from 2 μm to 25 μm. The amount of the semiconductor particles per $m^2$ of the support is preferably from 0.5 g to 400 g, more preferably from 5 g to 100 g.

The application of the semiconductor particles to the electrically conductive support is preferably followed by the electronical connection of the semiconductor particles as well as heat treatment for the purpose of enhancing the coat layer strength or the adhesivity to the support. The heating temperature is preferably from 40°C to lower than 700°C, more preferably from 100°C to not higher than 600°C. The heating time is from about 10 minutes to 10 hours. In the case where a support having a low melting point or softening point such as polymer film is used, high temperature treatment causes deterioration of the support to disadvantage. From the standpoint of cost, too, the heating temperature is preferably as low as possible. The lowering of the heating temperature can be accomplished by the use of the foregoing semiconductor particles having a particle diameter as small as 5 nm or less or heating in the presence of a mineral acid.

For the purpose of increasing the surface area of the semiconductor particles thus heat-treated or enhancing the purity in the vicinity of the semiconductor particles to increase the efficiency of injection of electrons from the dye to the semiconductor particles, chemical plating using an aqueous solution of titanium tetrachloride or electrochemical plating using an aqueous solution of titanium tetrachloride may be-effected.

The semiconductor particles preferably have a great surface area so that it can adsorb many dye particles. To this end, the surface area of the semiconductor particles layer applied to the support is preferably 10 or more times, more preferably 100 or more times the projected area. The upper limit of the surface area of the semiconductor particles layer is not specifically limited. In practice, however, it is normally about 1,000 times.

(3) Dye

As the dye to be incorporated in the photosensitive layer there is preferably used a metal complex dye, phthalocyanine-based dye or methine dye. In order to widen the wavelength range where photoelectric conversion is effected as much as possible and raise the conversion efficiency, two or more dyes may be used in admixture. The dyes to be mixed and their mixing ratio can be selected to attain the desired wavelength range and intensity distribution of light source.

The foregoing dye preferably has a proper interlocking group with respect to the surface of the semiconductor particles. Preferred examples of such an interlocking group include COOH group, OH group, $SO_3H$ group, cyano group, $-P(O)(OH)_2$ group, $-OP(O)(OH)_2$ group, and chelating group having $\pi$ conductivity such as oxim, dioxim, hydroxyquinoline, salicylate and $\alpha$-ketoenolate. Particularly preferred among these interlocking groups are COOH group, $-P(O)(OH)_2$ group, and $-OP(O)(OH)_2$ group. These groups may form a salt with alkaline metal or the like or may form an intramolecular salt. In the case where a polymethine dye is used, if it contains an acidic group as in the case where methine chain forms a squarilium ring or croconium ring, this moiety may act as an interlocking group.

The dye to be incorporated in the photosensitive layer will be further described hereinafter.

(a) Metal complex dye

If the dye is a metal complex dye, the metal atom is preferably ruthenium Ru. Examples of the ruthenium complex dye employable herein include complex dyes disclosed in U.S. Patents 4,927,721, 4,684,537, 5,084,365, 5,350,644, 5,463,057, and 5,525,440, JP-A-7-249790 (The term "JP-A" as used herein means an "unexamined published Japanese patent application"), JP-W-10-504512 (The term "JP-W" as used herein means an "international patent application published in the Japanese national proceeding"), and WO98/50393.

The ruthenium complex dye to be used in the invention is preferably represented by the following general formula (I):

$$(A_1)_p Ru(B\text{-}a)(B\text{-}b)(B\text{-}c) \qquad (I)$$

In the general formula (I), $A_1$ represents a ligand selected from the group consisting of Cl, SCN, $H_2O$, Br, I, CN, NCO and SeCN. The suffix p represents an integer of from 0 to 3. B-a, B-b and B-c each independently represent an organic ligand selected from the group consisting of compounds represented by the following general formulae B-1 to B-8:

B-1

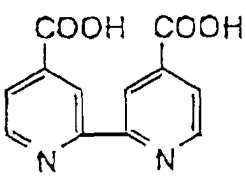

B-2

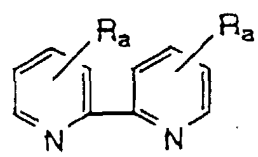

B-3

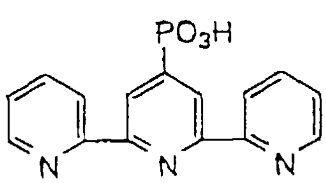

B-4

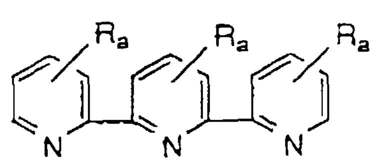

B-5

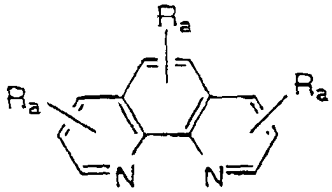

B-6

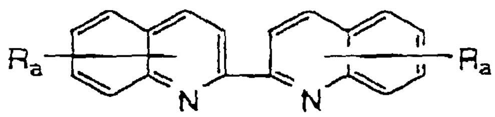

B-7

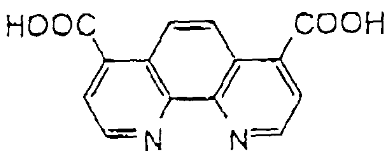

B-8

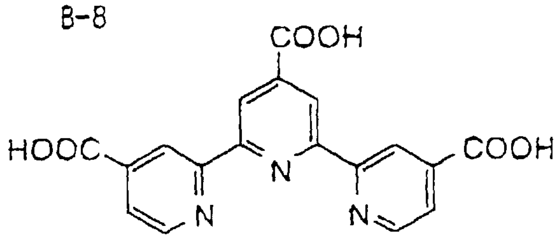

wherein $R_4$ represents a hydrogen atom or substituent such as halogen atom, substituted or unsubstituted alkyl group having 1 to 12 carbon atoms, substituted or unsubstituted aralkyl group having 7 to 12 carbon atoms, substituted or unsubstituted aryl group having 6 to 12 carbon atoms, carboxylic acid group or phosphoric acid group (these acid groups may form a salt) , with the proviso that the alkyl group and the alkyl moiety of the aralkyl group may be straight-chain or branched and the aryl group and the aryl moiety of the aralkyl group may be monocyclic or polycyclic (condensed ring, aggregation of rings). B-a, B-b and B-c may be the same or different.

Specific preferred examples of the metal complex salt will be listed below, but the present invention should not be construed as being limited thereto.

| No. | $A_1$ | p | B-a | B-b | B-c | $R_a$ |
|---|---|---|---|---|---|---|
| R-1 | SCN | 2 | B-1 | B-1 | - | - - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | 4, 4' $-COO^-N^+(n-C_4H_9)_4$ |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-8 | B-2 | - | 4, 4'$-COO^-N^+(n-C_4H_9)_4$ |
| R-13 | - | 0 | B-1 | B-1 | B-1 | - |

R-14

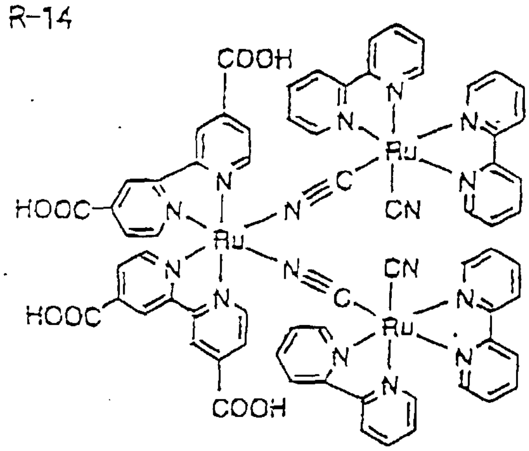

R-15

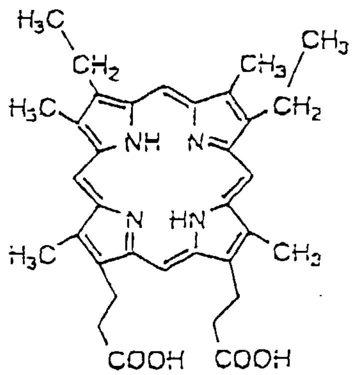

R-16

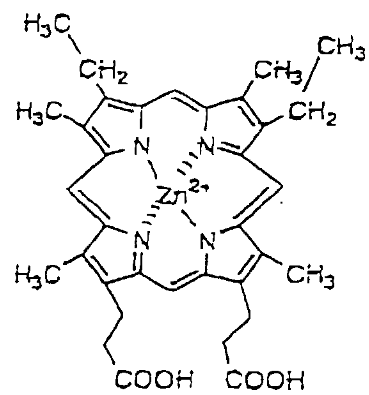

R-17

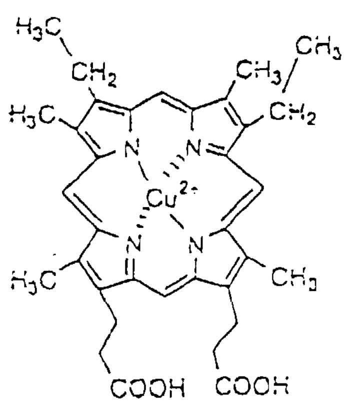

R-18

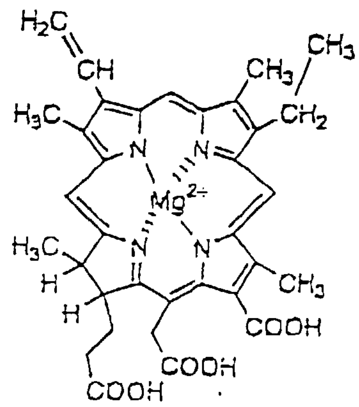

R-19

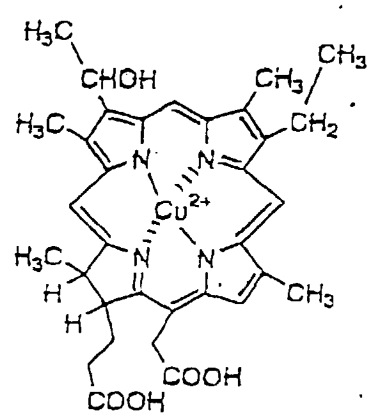

R-20

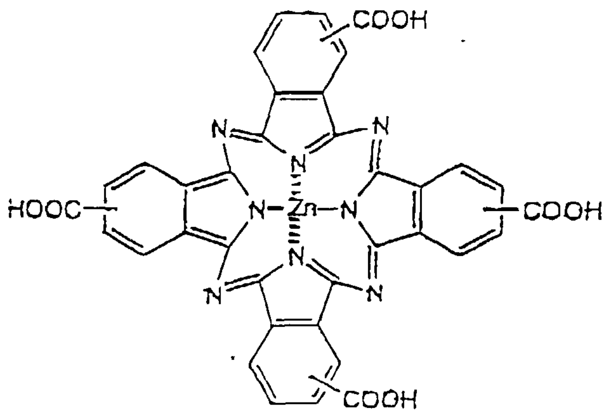

R-21

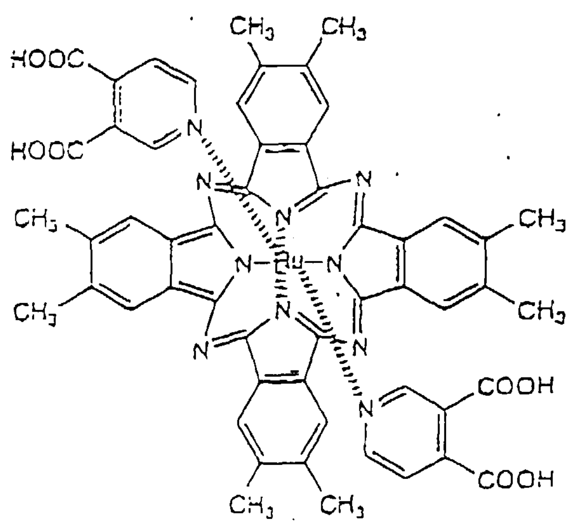

(b) Methine dye

The methine dye which can be preferably used in the invention is a dye described in JP-A-11-35836, JP-A-11-158395, JP-A-11-163378, JP-A-11-214730, JP-A-11-214731, EP892411, and EP911841. For the details of method for the synthesis of these dyes, reference can be made to F. M. Hamer, "Heterocyclic Compounds-Cyanine Dyes and Related Compounds", John Wiley & Sons, New York, London, 1964, D. M. Sturmer, "Heterocyclic Compounds-Special Topics in Heterocyclic Chemistry", Chapter 18, Section 14, pp. 482-515, John Wiley & Sons, New York, London, 1977, "Rodd's Chemistry of Carbon Compounds", 2nd Ed., Vol. IV, part B, 1977, Chapter 15, pp. 369 - 422, Elsevier Science

Publishing Company Inc., New York, British Patent 1,077,611, Ukrainskii Khimischeskii Zhurnal, vol. 40, No. 3, pp. 253 - 258, Dyes and Pigments, vol. 21, pp. 227-234, and literatures cited in these references.

(4) Adsorption of dye to semiconductor particles

In order to allow a dye to be adsorbed by the semiconductor particles, a well-dried electrically conductive support having semiconductor particles layer can be dipped in a dye solution or a dye solution may be applied to the semiconductor particles layer. In the case of the former method, dip method, roller method, air knife method or the like can be employed. If dip method is used, the adsorption of a dye may be effected at room temperature or may be effected during heating under reflux as described in JP-A-7-249790: Examples of the latter method, if it is coating method, include wire bar method, slide hopper method, extrusion method, curtain method, spin method, and spray method. Examples of the latter method, if it is printing method, include letterpress printing, offset printing, gravure printing, and screen printing. The solvent can be properly selected depending on the capability of dissolving a dye therein. Examples of the solvent employable herein include alcohols (e.g., methanol, ethanol, t-butanol, benzyl alcohol), nitriles (e.g., acetonitrile, propionitrile, 3-methoxypropionitrile), nitromethane, halogenated hydrocarbons (e.g., dichloromethane, dichloroethane, chloroform, chlorobenzene), ethers (e.g., diethylether, tetrahydrofuran), dimethylsulfoxide, amides (e.g., N,N-dimethylformamide, N,N-dimethylacetamide), N-methylpyrrolidone, 1,3-dimethylimidazolidinone, 3-methyloxazolidinone, esters (e.g., ethyl acetate, butyl acetate), carbonic acid esters (e.g., diethyl carbonate, ethylene carbonate, propylene carbonate), ketones (e.g., acetone, 2-butanone, cyclohexanone), hydrocarbons (e.g., hexane, petroleum ether, benzene, toluene), and mixture thereof.

Referring to the viscosity of the dye solution, if a high viscosity solution (e.g., 0.01 to 500 Poise) is used, various printing methods may be used besides extrusion method while if a low viscosity solution (e.g., 0.1 Poise or less) is used, slide hopper method, wire bar method or spin method may be used, as in the case where the semiconductor particles layer is formed. Any of these methods can form a uniform coat layer.

Thus, the method for the adsorption of a dye can be properly selected depending on the viscosity of the dye coating solution, the applied amount of the dye coating solution, the kind of the electrically conductive support, coating speed, etc. The time required until the semiconductor particles adsorb dye thus applied is preferably as short as possible taking into account mass producibility.

The presence of unadsorbed dye causes disturbance of the properties of the element. Thus, the unadsorbed dye is preferably removed rapidly after adsorption. It is preferred that the coated material be cleaned with a polar solvent such as acetonitrile or an organic solvent such as alcohol solvent in a wet cleaning tank. In order to increase the amount of the dye to be adsorbed, the semiconductor particles layer is preferably subjected to heat treatment before adsorption. In order to prevent water from being adsorbed by the surface of the semiconductor particles, the heat treatment is preferably immediately followed by the adsorption of the dye at a temperature of from 40°C to 80°C by the time when the temperature is returned to room temperature.

The total amount of the dye to be used is preferably from 0.01 to 100 mmol per unit surface area (1 $m^2$) of the electrically conductive support. The amount of the dye to be adsorbed by the semiconductor particles is preferably from 0.01 to 1 mmol per g of the semiconductor particles. With this adsorbed amount, the dye can exert a sufficient effect of sensitizing the semiconductor. On the contrary, when the adsorbed amount of the dye is too small, the resulting sensitizing effect is insufficient. When the adsorbed amount of the dye is too great, the dye which is not adsorbed by the semiconductor is suspended, causing the deterioration of the sensitizing effect.

In order to widen the wavelength range where photoelectric conversion is effected as much as possible and raise the conversion efficiency, two or more dyes may be used in admixture. The dyes to be mixed and their mixing ratio can be selected to attain the desired wavelength range and intensity distribution of light source.

For the purpose of lessening interaction such as association of dye particles, a colorless compound may be adsorbed to the semiconductor particles in combination with the dye. Examples of a hydrophobic compound to be co-adsorbed include steroid compound having carboxyl group (e.g., chenodeoxycholic acid). An ultraviolet absorber may be used as well.

For the purpose of accelerating the removal of excess dye, the adsorption of the dye may be followed by the treatment of the surface of the semiconductor particles with amines. Preferred examples of amines include pyridine, 4-t-butylpyridine, and polyvinylpyridine. Such an amine, if it is liquid, may be used as it is or may be used in the form of solution in an organic solvent.

(E) Counter electrode

The counter electrode acts as a positive electrode for photocell when the photoelectric conversion device is used as a photocell. The counter electrode may be in the form of single layer structure comprising a counter electrode electrically-conductive layer made of an electrically-conductive material or may consist of a counter electrode electrically-conductive layer and a supporting substrate as in the case of the foregoing electrically conductive support. Examples of the electrically-conductive material to be used in the counter electrode electrically-conductive layer include metal (e.g., platinum, gold, silver, copper, aluminum, magnesium, rhodium, indium), carbon, and electrically-conductive metal oxide (e.g., indium-tin composite oxide, tin oxide doped with fluorine). Among these electrically-conductive materials, platinum, gold, silver, copper, aluminum or magnesium is preferably used as a counter electrode layer. Preferred examples of the supporting substrate for the counter electrode include glass, and plastic. The foregoing electrically-conductive agent is then applied or vacuum-evaporated onto such a supporting substrate. The thickness of the counter electrode electrically-conductive layer is not specifically limited. In practice, however, it is preferably from 3 nm to 10 µm. If the counter electrode electrically-conductive layer is made of a metal, its thickness is preferably 5 µm or less, more preferably from 5 nm to 3 pm. The surface resistivity of the counter electrode layer is preferably as low as possible. The surface resistivity of the counter electrode electrically-conductive layer is preferably 80 Ω/square or less, more preferably 20 Ω/square or less.

Either or both of the electrically conductive support and the counter electrode may be irradiated with light. Accordingly, in order to allow light to reach the photosensitive layer, at least one of the electrically conductive support and the counter electrode may be substantially transparent. From the standpoint of enhancement of efficiency of generation of electricity, the electrically conductive support is preferably transparent so that light can enter into the photoelectric conversion device on the electrically conductive support side thereof. In this case, the counter electrode is preferably capable of reflecting light. As such a counter electrode there may be used glass or plastic having a metal or electrically-conductive oxide vacuum-evaporated thereon or a thin metal film.

The counter electrode may be formed by directly applying, plating or vacuum-evaporating (PVD, CVD) an. electrically-conductive material onto the positive hole-transporting layer or by sticking a substrate having an electrically-conductive layer to the positive hole-transporting layer on the electrically-conductive layer side thereof. For the purpose of lowering the resistivity of the counter electrode, if the counter electrode is transparent in particular, a metal lead is preferably used as in the case of the electrically conductive support. The preferred material constituting the metal lead, method for disposing the metal lead, reduction of the amount of incident light by the disposition of the metal lead, etc. are as in the case of the electrically conductive support.

(F) Other layers

Either or both of the electrically conductive support and the counter electrode which act as electrode may be provided with a functional layer such as protective layer and anti-reflection layer. If a plurality of such functional layers are formed, simultaneous multi-layer coating method or successive coating method may be used. From the standpoint of productivity, simultaneous multi-layer coating method is preferred. The simultaneous multi-layer coating method preferably involves slide hopper method or extrusion method taking into account the productivity and the uniformity of the coat layer. The formation of such a functional layer may be accomplished by vacuum-evaporation method or laminating method depending on the material of the functional layer.

(G) Specific examples of internal structure of photoelectric conversion device

As mentioned above, the internal structure of the photoelectric conversion device may be in various forms depending on the purpose. The internal structure of the photoelectric conversion device can be roughly divided into two groups, i.e., structure allowing the entrance of light beam from the both surfaces thereof and structure allowing the entrance of light beam from one surface thereof. The internal structure of the photoelectric conversion device which can be preferably used in the invention is exemplified in Figs. 2 to 9.

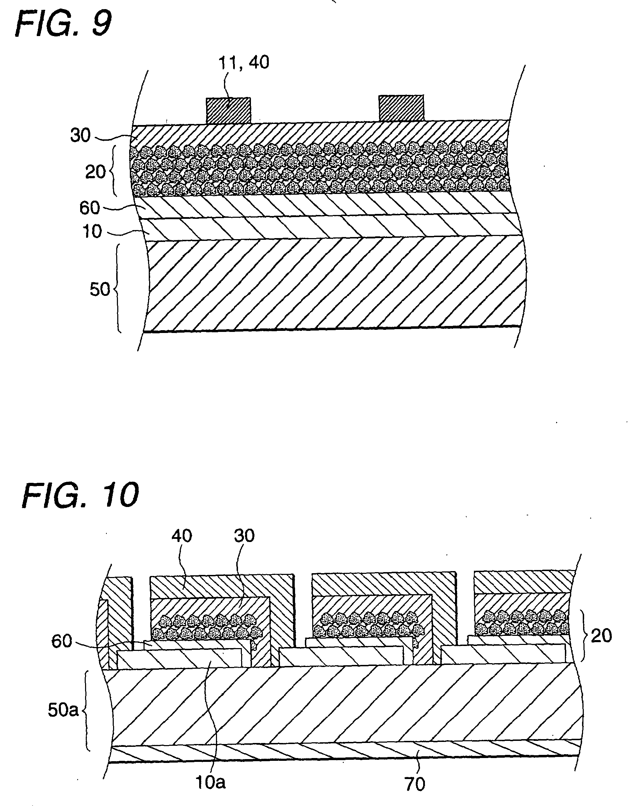

In Fig. 2, a photosensitive layer 20 and a positive hole-transporting layer 30 are provided interposed between a transparent electrically-conductive layer 10a and a transparent counter electrode electrically-conductive layer 40a to provide a structure allowing the entrance of light beam from the both surfaces thereof. In Fig. 3, a metal lead 11 is provided partly on a transparent substrate 50a. A transparent electrically-conductive layer 10a is provided on the transparent substrate 50a and the metal lead 11. An undercoat layer 60, a photosensitive layer 20, a positive hole-transporting layer 30 and a counter electrode electrically-conductive layer 40 are provided on the transparent electrically-conductive layer 10a in this order. A supporting substrate 50 is provided on the counter electrode electrically-conductive layer 40. This arrangement gives a structure allowing the entrance of light beam from the electrically-conductive layer side thereof. In Fig. 4, an electrically-conductive layer 10 is provided on a supporting substrate 50. A photosensitive layer 20 is provided on the electrically-conductive layer 10 with an undercoat layer 60 provided interposed therebetween. A positive hole-transporting layer 30 and a transparent counter electrode electrically-conductive layer 40a are provided on the photosensitive layer 20. A transparent substrate 50a having a metal lead 11 provided partly therein is provided on the positive hole-transporting layer 30 with the metal lead 11 facing inward. This arrangement gives a structure allowing the entrance of light beam from the counter electrode side thereof. In Fig. 5, a metal lead 11 is

provided partly on a transparent substrate 50a. A transparent electrically-conductive layer 10a is provided on the transparent substrate 50a and the metal lead 11. An undercoat layer 60, a photosensitive layer 20, a positive hole-transporting layer 30 and a transparent counter electrode electrically-conductive layer 40a are provided interposed between a pair of the foregoing laminates. This arrangement gives a structure allowing the entrance of light beam from the both surfaces thereof. In Fig. 6, a transparent electrically-conductive layer 10a, a photosensitive layer 20, a positive hole-transporting layer 30 and a counter electrode electrically-conductive layer 40 are provided on a transparent substrate 50a. A supporting substrate 50 is provided on the counter electrode electrically-conductive layer 40. This arrangement gives a structure allowing the entrance of light beam from the electrically-conductive layer side thereof. In Fig. 7, an electrically-conductive layer 10 is provided on a supporting substrate 50. A photosensitive layer 20 is provided on the electrically-conductive layer 10 with an undercoat layer 60 provided interposed therebetween. A positive hole-transporting layer 30 and a transparent counter electrode electrically-conductive layer 40a are provided on the photosensitive layer 20. A transparent substrate 50a is provided on the transparent counter electrode electrically-conductive layer 40a. This arrangement gives a structure allowing the entrance of light beam from the counter electrode side thereof. In Fig. 8, a transparent electrically-conductive layer 10a is provided on a transparent substrate 50a. A photosensitive layer 20 is provided on the transparent electrically-conductive layer 10a with an undercoat layer 60 provided interposed therebetween. A positive hole-transporting layer 30 and a transparent counter electrode electrically-conductive layer 40a are provided on the photosensitive layer 20. A transparent substrate 50a is provided on the transparent counter electrode electrically-conductive layer 40a. This arrangement gives a structure allowing the entrance of light beam from the both surfaces thereof. In Fig. 9, an electrically-conductive layer 10 is provided on a supporting substrate 50. A photosensitive layer 20 is provided on the electrically-conductive layer 10 with an undercoat layer 60 provided interposed therebetween. A solid positive hole-transporting layer 30 is provided on the photosensitive layer 20. A counter electrode electrically-conductive layer 40 or metal lead 11 is provided partly on the solid positive hole-transporting layer 30. This arrangement gives a structure allowing the entrance of light beam from the counter electrode side thereof.

[2] Photocell

The photocell of the invention is arranged such that the foregoing photoelectric conversion device works on an external circuit. The photocell is preferably sealed with a polymer or adhesive at the side face thereof to prevent the deterioration of the constituents and the evaporation of the contents. The external circuit which is connected to the electrically conductive support and the counter electrode via a lead wire may be known itself. In the case where the photoelectric conversion device of the invention is applied to photocell, the internal structure of the cell is basically the same as that of the foregoing photoelectric conversion device. The module structure of a photocell comprising the photoelectric conversion device of the invention will be described hereinafter.

The dye-sensitized photocell of the invention can basically have the same module structure as the conventional photocell module. A photocell module normally comprises a cell formed on a supporting substrate such as metal and ceramics. The cell is covered by a filling resin, protective glass or the like. This arrangement gives a structure allowing the entrance of light beam from the side thereof opposite the supporting substrate. In a modified version, the cell may be formed on a reinforced glass or other transparent materials as a supporting substrate so that light beam can enter on the supporting substrate side thereof. Specific known examples of photocell module include module structure called superstraight type module, substraight type module and potting type module, and substrate-integrated module structure as used in amorphous silicon solar cell. The dye-sensitized photocell of the invention may properly have any of these module structures depending on the purpose, where to use, and environmental conditions.

As a representative type of module, the superstraight type or substrate type of module comprises cells arranged equally apart from each other between a pair of supporting substrates each of which is transparent on one or both sides thereof and has been subjected to anti-reflection treatment. The adjacent cells are connected to each other via a metal lead or flexible wiring. A collector electrode is provided at the outer end of the cells. This arrangement gives a structure allowing the external supply of electricity thus generated. Various types of plastic materials such as ethylene vinyl acetate (EVA) may be provided interposed between the substrate and the cell in the form of film or filling resin for the purpose of protecting the cell or enhancing the efficiency of collection of electricity. In the case where the cell is used at the site where the surface of the cell doesn't need to be covered by a hard material, i.e., where the cell is little subject to external impact, the surface protective layer may be formed by a transparent plastic film or the filling resin may be hardened to protect the cell, making it possible to omit one of the supporting substrates. The photocell module is fixed at the supporting substrate by sandwiching the module by a metal frame to secure the sealing of interior of the module and the rigidity of the module. The gap between the supporting substrate and the frame is sealed with a sealing material. If the cell itself, the supporting substrate and the sealing material are made of flexible materials, the resulting photocell can be formed on a curved surface.

The superstraight type of solar photocell module can be prepared, e.g., by laminating a cell, a sealing material, a cell connecting lead wire, a back sealing material, etc. in sequence on a front substrate which has been discharged

from a substrate supplier and is being conveyed on a conveyor or the like, putting a back substrate or back cover on the laminate, and then fixing a frame to the outer periphery of the laminate.

On the other hand, the substraight type of solar photocell module can be prepared by laminating a cell, a cell connecting lead wire, a sealing material, etc. on a supporting substrate which has been discharged from a substrate supplier and is being conveyed on a conveyor or the like, putting a front cover on the laminate, and then fixing a frame to the outer periphery of the laminate.

An example of the structure of the photoelectric conversion device of the invention in the form of substrate-integrated module is shown in Fig. 10. In the cell module of Fig. 10, a transparent electrically-conductive layer 10a is provided on one side of a transparent substrate 50a. An undercoat layer 60 is provided on the transparent electrically-conductive layer 10a. A photosensitive layer 20 containing dye-adsorbed $TiO_2$, a positive hole-transporting layer 30 and a metallic counter electrode electrically-conductive layer 40 are provided on the undercoat layer 60. The substrate 50a has an anti-reflection layer 70 provided on the other side thereof. If this structure is taken, the area ratio of the photosensitive layer 20 (as viewed from the substrate 50a side thereof, upon which light beam is incident) is preferably great to enhance the efficiency of utilization of incident light.

In the case of the module having the structure shown in Fig. 10, by patterning on the substrate using semiconductor process techniques such as selective plating, selective etching, CVD and PVD or mechanical methods such as laser scribing, plasma CVM (as described in "Solar Energy Materials and Solar Cells", 48, pp. 373 - 381) and cutting after pattern coating or wide coating such that a transparent electrically-conductive layer, a photosensitive layer, a positive hole-transporting layer, an counter electrode, etc. are arranged three-dimensionally and at a predetermined interval, a desired module structure can be obtained.

Other members and production processes will be described in detail hereinafter.

As a sealing material there may be used any of various materials such as liquid EVA (ethylene vinyl acetate), film-like EVA and mixture of vinylidene fluoride copolymer and acrylic resin depending on the purpose of providing weathering resistance and electrical insulation, enhancing the efficiency of collection of light and the cell protecting properties (impact resistance). The gap between the outer periphery of the module and the surrounding frame is preferably sealed with a sealing material having a high weathering resistance and moistureproofness. Further, the sealing material may comprise a transparent filler incorporated therein to enhance the strength or light transmittance thereof.

In order to fixing the sealing material onto the cell, a method suitable for the physical properties of the sealing material may be used. In the case of film-like material, heat bonding after rolling, heat bonding after pressing in vacuo, etc. may be employed. In the case of paste-like material, various methods such as roll coating method, bar coating method, spray coating method and screen printing method may be employed.

When as a supporting substrate there is used a flexible material such as PET and PEN, a sealing layer can be continuously laminated as mentioned above on a cell which has been formed on a support which is being discharged from a coil. This method gives a high productivity.

In order to enhance the efficiency of generation of electricity, the module is subjected to anti-reflection treatment on the surface of the substrate (normally reinforced class) from which light beam enters in the module. Examples of anti-reflection treatment include method involving the lamination of an anti-reflection film, and method involving the coating of an anti-reflection layer.

The cell can be subjected to surface treatment such as grooving and texturing to enhance the efficiency of utilization of incident light beam.

In order to enhance the efficiency of generation of electricity, it is most important to take light beam into the module without any loss. It is also important to allow light beam which has been transmitted by the photoelectric conversion layer and reached the interior thereof to be reflected and returned to the photoelectric conversion layer at a high efficiency. Examples of the method for enhancing the reflectance include method which comprises vacuum-evaporating or plating Ag, Al or the like onto the mirror-polished surface of a supporting substrate, method which comprises providing as an anti-reflection layer a layer of alloy such as Al-Mg and Al-Ti at the lowest position from the cell, and method which comprises annealing to form a texture in the lowest layer.

In order to enhance the efficiency of generation of electricity, it is important to lower the connecting resistivity between the cells and hence inhibit the drop cf the internal voltage. In order to connect cells, wire bonding or connection by an electrically-conductive flexible sheet is normal. Alternatively, a method may be used which comprises fixing cells with an electrically-conductive adhesive tape or electrically-conductive adhesive while electrically connecting the cells to each other. Further, a method may be used which comprises patternwise applying an electrically-conductive hot melt to desired areas.

In the solar photocell comprising a flexible support such as polymer film, the main body of the photocell can be prepared by forming sequentially cells in the foregoing manner on a support which is being discharged from a coil, cutting the support to a desired size, and then sealing the edge of the support with a flexible and moistureproof material. The solar photocell may be in the form of a module structure called "SCAF" described in "Solar Energy Materials and Solar Cells", 48, pp. 383 - 391. The solar photocell comprising such a flexible support can also be bonded to a curved

glass.

As mentioned in detail above, solar photocells having various shapes and functions can be prepared according to the purpose and environmental conditions.

EXAMPLE

The present invention will be further described in the following examples.

1. Preparation of titanium dioxide dispersion

142.1 g of titanium tetraisopropoxide and 149.2 g of triethanolamine were mixed in a dry box at room temperature, and then allowed to stand for 2 hours. The mixture was withdrawn from the dry box, and then diluted with distilled water to make 1,000 ml. Thus, a mother liquor was prepared. 100 ml of the mother liquor and 100 ml of diluted acetic acid obtained by diluting 2.85 ml of acetic acid with distilled water were then mixed. The mixture was then heated to a temperature of 100°C in a sealed vessel for 24 hours to form a white gel-like material. The temperature was raised to 140°C where the gel-like material was then heated for 72 hours. The material was then cooled to room temperature. The resulting supernatant liquid was then removed to obtain a light red brown precipitate. The weight of the resulting hydrous precipitate was 33 g. To the precipitate thus obtained was then added 1.0 g of a polyethylene glycol having a molecular weight of 500,000. The mixture was then kneaded by a kneader for 20 minutes to obtain a titanium dioxide dispersion having a mass concentration of 12% as a dispersion 1. The average diameter of titanium dioxide particles contained in the dispersion 1 was about 16 nm. The relative standard deviation of particle diameter distribution was 28%.

2. Preparation of dye-adsorbed $TiO_2$ electrode

2-1. Electrode A (free of undercoat layer)

An adhesive tape was applied as a spacer to a part (3 mm from the end) of an electrically-conductive glass coated with tin oxide doped with fluorine (produced by Nippon Sheet Glass Co., Ltd.; 25 mm x 100 mm; area resistivity: 10 Ω/square). The foregoing titanium dioxide dispersion was then applied to the electrically-conductive glass using a glass rod. After coating, the adhesive tape was then peeled off from the electrically-conductive glass. The electrically-conductive glass was then air-dried at room temperature for 1 hour. Subsequently, the electrically-conductive glass was calcined at a temperature of 550C in an electric furnace (Type FP-32 muffle furnace, produced by Yamato Scientific Co., Ltd.). The electrically-conductive glass was withdrawn from the electric furnace, cooled in an atmosphere of dew point minus 40°C until the temperature of the surface of the electrode reached 120°C, and then dipped in an ethanol solution of Dye R-6 ($3 \times 10^{-4}$ mol/l) at a temperature of 40°C for 4 hours. The resulting dye-adsorbed electrode was washed with acetonitrile, air-dried, and then cut to a size of 22 mm x 19 mm. As a result, an electrode A was obtained. The applied amount of the photosensitive layer thus obtained (dye-adsorbed titanium dioxide layer) was 9.0 $g/m^2$.

2-2. Electrode B (with undercoat layer)

An electrode B was obtained in the same manner as the electrode A except that an electrically-conductive glass (produced by Nippon Sheet Glass Co., Ltd.; 25 mm x 100 mm; area resistivity: 10 Ω/square) was partly (5 mm from the end) protected by a glass on the electrically-conductive side thereof, and the electrically-conductive glass thus protected was put on a 400°C hot plate where it was then subjected to spray pyrolysis (spraying with a solution of 5.68 g of titanium isopropoxide in a mixture of 4.1 ml of acetyl acetone and 80 ml of ethanol) to form a thin layer of titanium dioxide as an undercoat layer (thickness: about 30 nm). The applied amount of the photosensitive layer thus obtained (dye-adsorbed titanium dioxide layer) was 8.8 $g/m^2$.

3. Formation of positive hole-transporting layer

A positive hole-transporting layer A for comparison was prepared by the following coating step A.

A positive hole-transporting layer B of the invention was prepared by the following electroless plating step followed by the following post-step A.

A positive hole-transporting layer C of the invention was prepared by the following electroless plating step followed by the post-step A, which is in turn followed by the following coating step B.

A positive hole-transporting layer D of the invention was prepared by the following electroless plating step followed by the post-step B, which is in turn followed by the following coating step B.

A positive hole-transporting layer E of the invention was prepared by the following electroless plating step followed by the coating step B.

A positive hole-transporting layer F of the invention was prepared by the following pre-treatment step followed by the electroless plating step, which is in turn followed by the post-step B, which is further in turn followed by

the coating step B.
3-1. Coating step A

The electrode (A or B) prepared in Clause 2 was protected at the area where the electrically-conductive surface was exposed and the periphery (1-mm width) of the photosensitive layer. The electrode was then allowed to stand on a hot plate which had been heated to a temperature of 100°C for 2 minutes. 0.2 ml of an acetonitrile solution of γ-CuI (3.2% by weight) was slowly applied to the electrode while acetonitrile was being evaporated in about 10 minutes. After coating, the electrode was then allowed to stand on the hot plate for 2 minutes to prepare a CuI (positive hole-transporting) layer. When observed by section SEM, the positive hole-transporting layer was confirmed to have partly penetrated into a porous layer formed by semiconductor particles in the electrode (A or B).

3-2. Electroless plating step

A plating solution having the following composition was prepared.

| Plating solution | |
|---|---|
| Sodium hydroxide | 10 g |
| Copper sulfate pentahydrate | 10 g |
| EDTA2Na dihydrate | 30 g |
| Formaldehyde | 4 g |
| 2,2'-Dipyridyl | 50 mg |
| NaCN | 30 mg |
| $K_2Ni(CN)_4$ | 15 mg |
| PEG1000 | 25 mg |
| Water to make | 1 l |

The plating solution thus prepared had a pH value of 12.

The electrode (A or B) prepared in Clause 2 which had been protected at the area where the electrically-conductive surface was exposed and the periphery (1-mm width) of the photosensitive layer was dipped in the plating solution which had been kept at a temperature of 50°C and was being aerated for about 1 hour, washed, and then dried to form a Cu layer thereon.

3-3. Post-step A

The Cu layer formed by electroless plating was then aged at room temperature in a sealed iodine vapor atmosphere for 1 hour to convert the Cu layer to a CuI layer. When observed by section SEM, the positive hole-transporting layer thus formed was confirmed to have penetrated deep into the porous semiconductor layer in the electrode.

3-4. Post-step B

The Cu layer formed by electroless plating was dipped in a 10 mmol aqueous solution of potassium iodide at room temperature for 5 minutes to form a CuI layer thereon.

3-5. Coating step B

The electrode on which a CuI layer had been formed at the post-step A or B or a Cu layer had been formed by plating step was subjected to the same treatment as in the formation of CuI layer at the coating step A to further form a CuI layer thereon. The CuI layer thus obtained at the coating step B was confirmed to have been formed by a relatively great crystal.

3-6. Pre-treatment step

The electrode (A or B) prepared in Clause 2 which had been protected at the area where the electrically-conductive surface was exposed and the periphery (1-mm width) of the photosensitive layer was dipped in a colloid solution obtained by dissolving palladium chloride and tin chloride in hydrochloric acid for 15 minutes, washed with water, and then dipped in diluted sulfuric acid so that it was cleaned.

4. Preparation of photocell

A photocell was prepared by laminating a platinum-deposited glass (thickness of platinum layer: 1 μm; thickness of glass layer: 1.1 mm; size: 1 cm x 2.5 cm) on the positive hole-transporting layer formed at Clause 3. In this manner, photocells comprising a glass layer 50a, an electrically-conductive layer 10a, a $TiO_2$ undercoat layer 60 (only when the electrode B was used), a dye-adsorbed $TiO_2$ electrode layer 20, a positive hole-transporting layer 30, and a counter electrode (platinum layer 40 + glass 50a) sequentially laminated as shown in Fig. 1 and having combinations of titanium dioxide electrode and positive hole-transporting layer as set forth in Table 1 were

prepared.

5. Measurement of efficiency of photoelectric conversion

A simulated sunlight was generated by passing light from a 500 W xenon lamp (produced by USHIO INC.) through a spectral filter (AM1.5G, produced by Oriel Inc.).

This simulated sunlight had an intensity of 100 mW/cm$^2$.

The foregoing photocell was then irradiated with this simulated sunlight. The electricity generated at the gap between the electrically-conductive glass and the counter electrode layer was then measured by a current-voltage meter (Type 5MU2400, produced by Keithley Instrument Inc.). The measurements are set forth in Table 1 as initial conversion efficiency ($\eta$). The photocell thus measured was shielded from light, allowed to stand under low moisture conditions for 24 hours, and then again measured for conversion efficiency. The measurements are set forth in Table 1 as conversion efficiency after aging. The percent of occurrence of shortcircuiting per 20 samples of photocell comprising various electrodes are also set forth in Table 1.

The "penetration of positive hole-transporting layer into porous layer" set forth in Table 1 was visually judged on the basis of observation by section SEM. (Δ: insufficient; O: good; ◎ very good)

Table 1

| Photocell | | Positive hole-transporting layer | Electrode | Penetration into porous layer | % Occurrence of short-circuiting | % Initial conversion efficiency | % Conversion efficiency after aging |
|---|---|---|---|---|---|---|---|
| 101 | Comparative | A | A | Δ | 70 | 0.4 | 0.1 |
| 102 | Comparative | A | B | Δ | 55 | 0.3 | < 0.1 |
| 103 | Invention | B | A | ○ | 30 | 1.2 | 1.1 |
| 104 | Invention | B | B | ○ | 15 | 1.1 | 1.0 |
| 105 | Invention | C | A | ○ | 5 | 0.9 | 0.9 |
| 106 | Invention | C | B | ○ | 0 | 1.1 | 1.0 |
| 107 | Invention | D | A | ○ | 0 | 1.3 | 1.2 |
| 108 | Invention | D | B | ○ | 0 | 1.4 | 1.2 |
| 109 | Invention | E | A | ○ | 5 | 0.7 | 0.6 |
| 110 | Invention | E | B | ○ | 0 | 0.6 | 0.6 |
| 111 | Invention | F | A | ◎ | 10 | 1.4 | 1.3 |
| 112 | Invention | F | B | ◎ | 0 | 1.2 | 1.2 |

Table 1 shows that the photocells 103 to 112 of the invention exhibit an excellent penetration into porous layer, a low occurrence of shortcircuiting, a high conversion efficiency and little deterioration with time as compared with the comparative photocells 101 and 102. The comparison of the photocells 103 and 104, the photocells 105 and 106, the photocells 109 and 110 and the photocells 111 and 112 show that the photocells comprising the electrode B (104, 106, 110, 112) exhibit a less occurrence of shortcircuiting than the others, demonstrating that the thin titanium dioxide undercoat layer has an effect of inhibiting shortcircuiting. The comparison of the photocells 103 and 104 with the photocells 105 and 106, which had been subjected to the coating step B, shows that the latter photocells exhibit a reduced occurrence of shortcircuiting, demonstrating that the coating step B has an effect of preventing shortcircuiting. The comparison of the photocells 103 to 106, which had been subjected to the post-step A, with the photocells 107, 108, 111 and 112, which had been subjected to the post-step B, shows that the post-step B gives a slightly higher conversion efficiency than the other. Even the photocells 109 and 110 show generation of photocurrent, demonstrating that Cu layer is partly converted to CuI during the coating step B.

As mentioned above, the photoelectric conversion device of the invention has a structure excellent in durability and thus exhibits a low percent of occurrence of shortcircuiting, a high conversion efficiency and little deterioration with time. Accordingly, a photocell comprising such a photoelectric conversion device is extremely useful as a photoelecticity generating element.

## Claims

**1.** A photoelectric conversion device comprising: an electrically conductive support;

a photosensitive layer containing semiconductor particles having a dye adsorbed thereby;
a positive hole-transporting layer; and
a counter electrode,
wherein said positive hole-transporting layer is prepared by a method comprising an electroless plating step.

**2.** The photoelectric conversion device according to Claim 1, wherein said electroless plating step is a step of effecting electroless metal plating and said method further comprises a post-step of converting the plating metal to a positive hole-transporting material.

**3.** The photoelectric conversion device according to Claim 1, wherein said method is a reduction method.

**4.** The photoelectric conversion device according to Claim 3, wherein said reduction method comprises a plating step of effecting electroless metal plating and a step of converting the plating metal to metal iodide or metal thiocyanate.

**5.** The photoelectric conversion device according to Claim 2 or 4, wherein said metal is copper.

**6.** The photoelectric conversion device according to Claim 2, wherein said positive hole-transporting material comprises at least one p-type compound semiconductor positive hole-transporting material.

**7.** The photoelectric conversion device according to Claim 6, wherein said p-type compound semiconductor is a compound semiconductor containing monovalent copper.

**8.** The photoelectric conversion device according to Claim 7, wherein said compound semiconductor containing monovalent copper comprises at least one of copper iodide and copper thiocyanate.

**9.** The photoelectric conversion device according to claim 1, wherein said electrically-conductive support, said photosensitive layer having a porous semiconductor sensitized with a dye, a solid electrolyte and said counter electrode are sequentially laminated.

**10.** The photoelectric conversion device according to Claim 9, wherein said solid electrolyte penetrates into said porous semiconductor layer deeply.

**11.** The photoelectric conversion device according to Claim 9, wherein a semiconductor layer for preventing shortcircuiting is laminated between said photosensitive layer and said electrically-conductive support.

**12.** A photocell comprising a photoelectric conversion device according to any one of Claims 1 to 11.

13. A photocell module comprising a photoelectric conversion device according to any one of Claims 1 to 11.

14. A process for the production of a positive hole-transporting layer for use in a photoelectric conversion device, which comprises an electroless plating step.

15. A method for manufacturing a photoelectric conversion device comprising an electrically conductive support, a photosensitive layer containing semiconductor particles having a dye adsorbed thereby, a positive hole-transporting layer and a counter electrode, which comprises a step of preparing the positive hole-transporting layer by a method including an electroless plating step.

FIG. 1

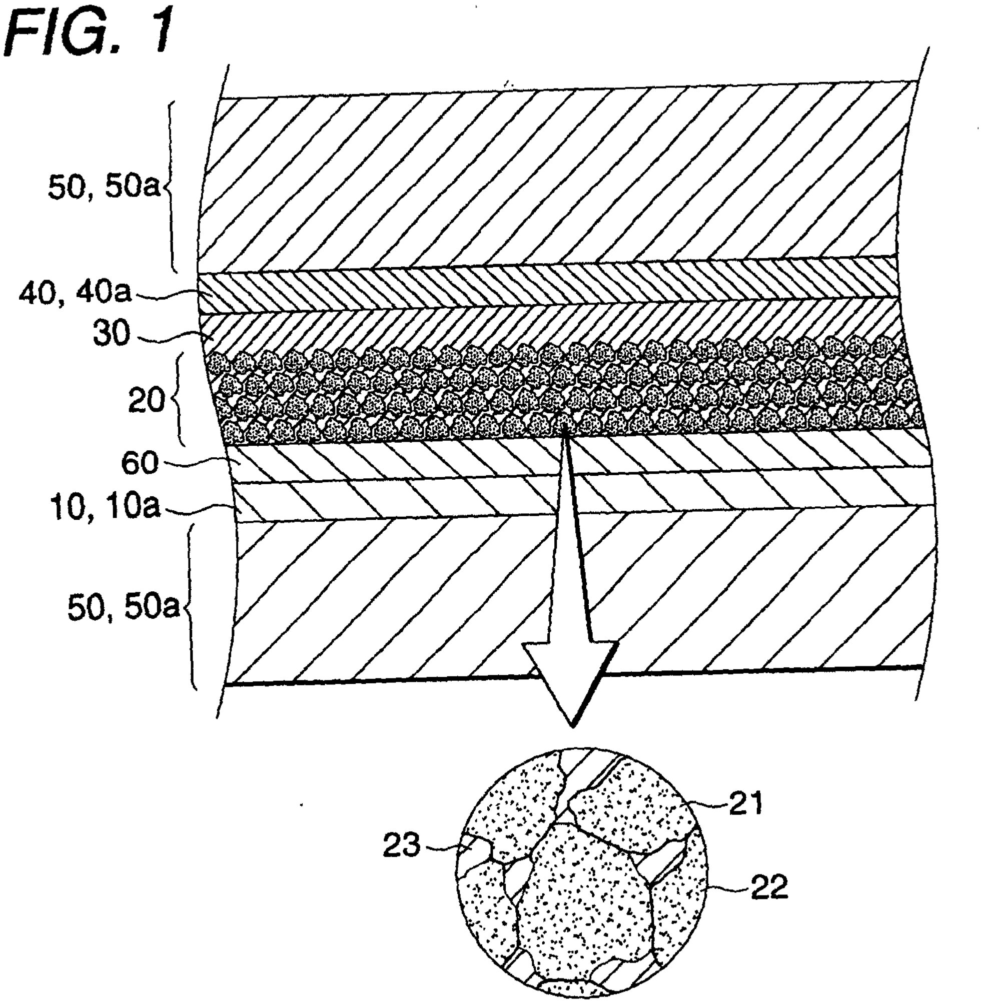


FIG. 2

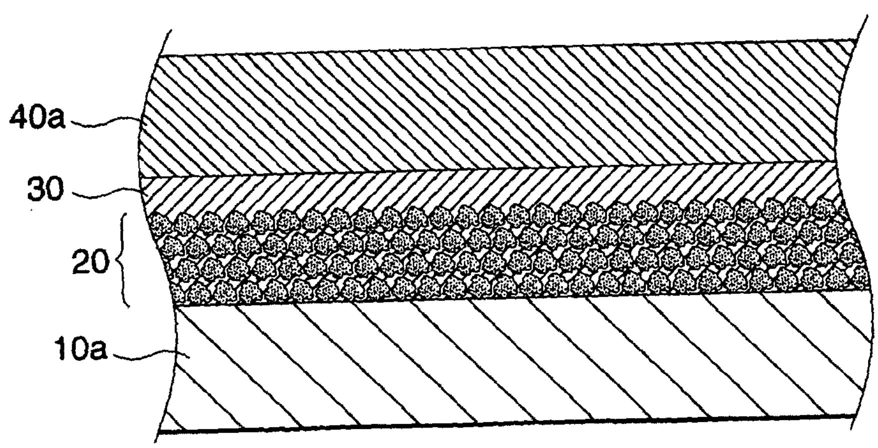

FIG. 3

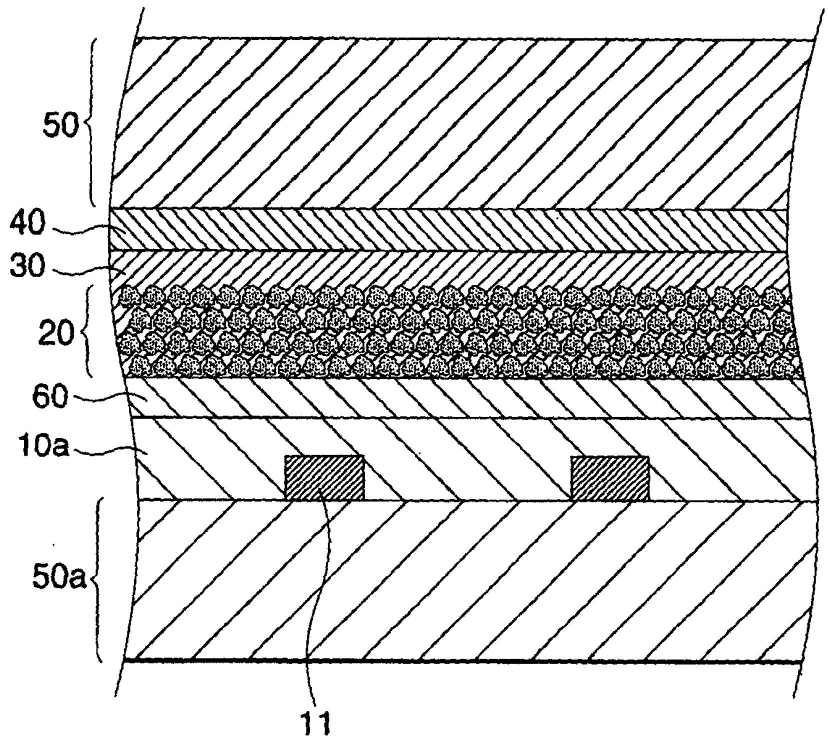


FIG. 4

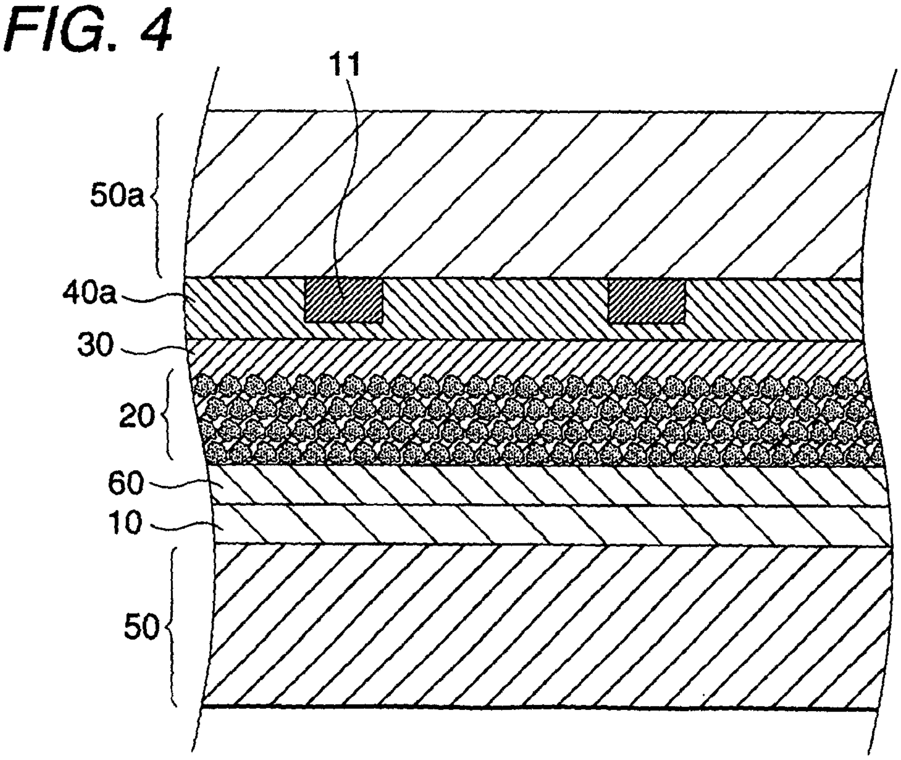

FIG. 5

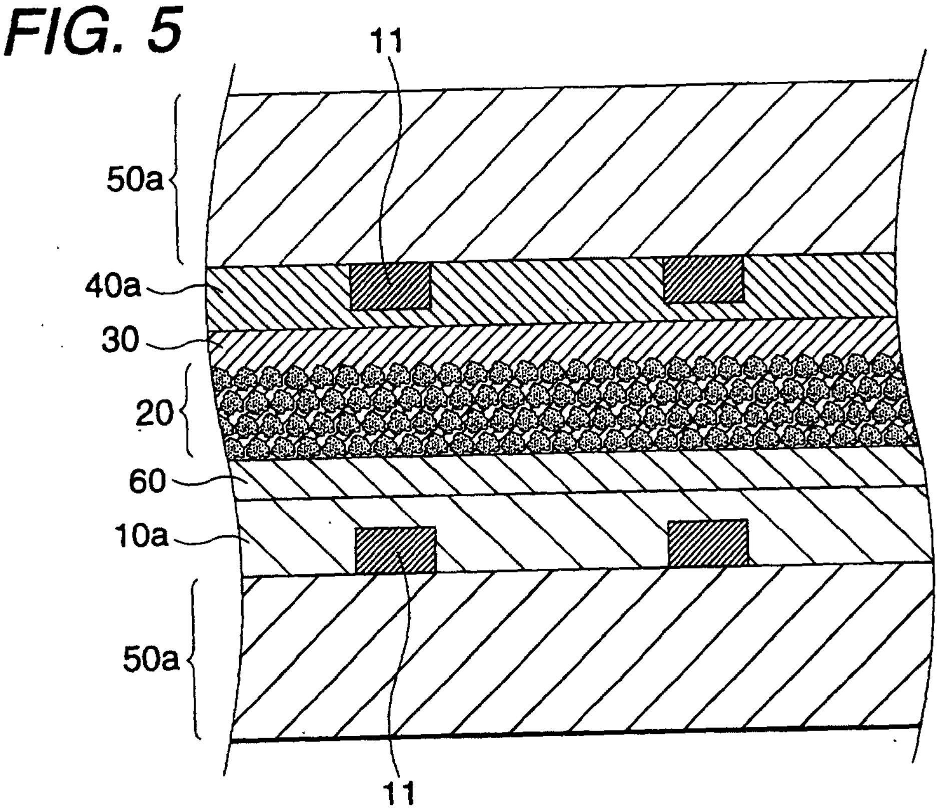


FIG. 6

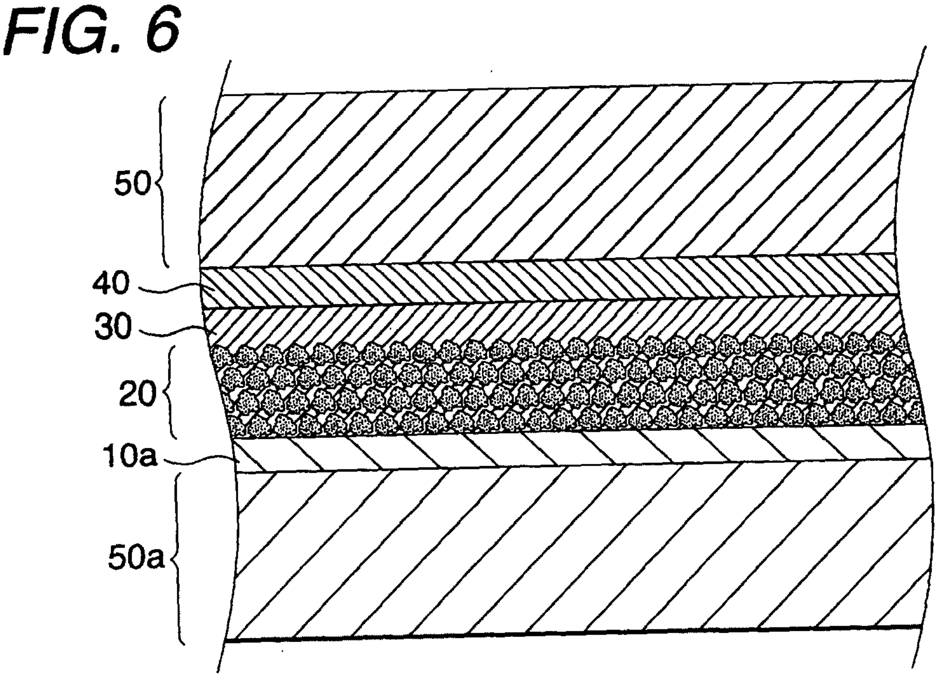

FIG. 7

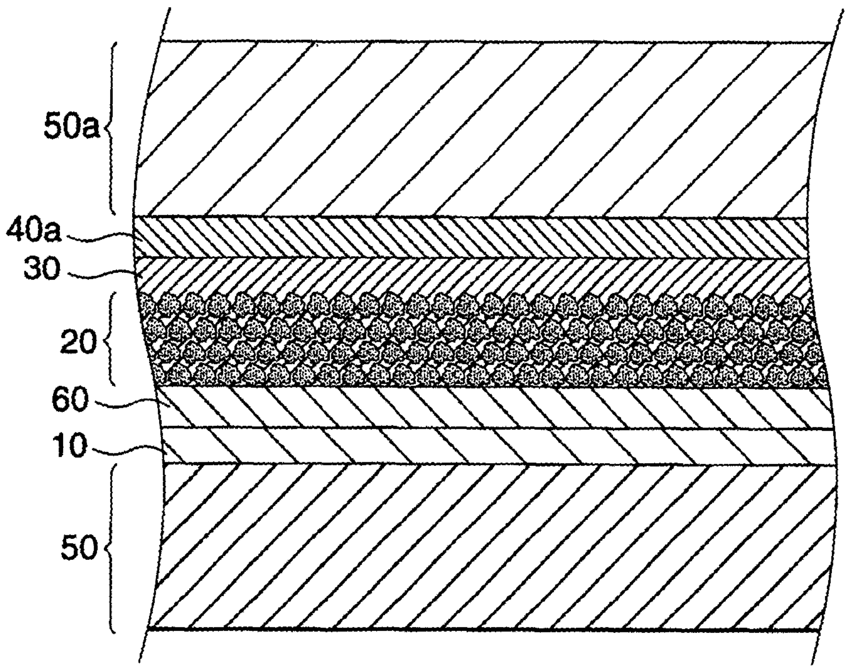


FIG. 8

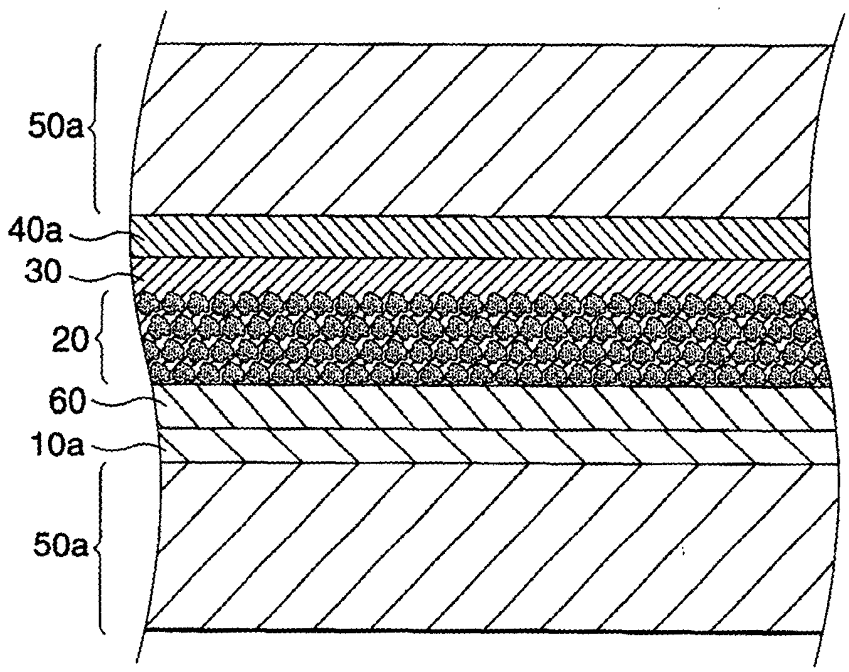

FIG. 9

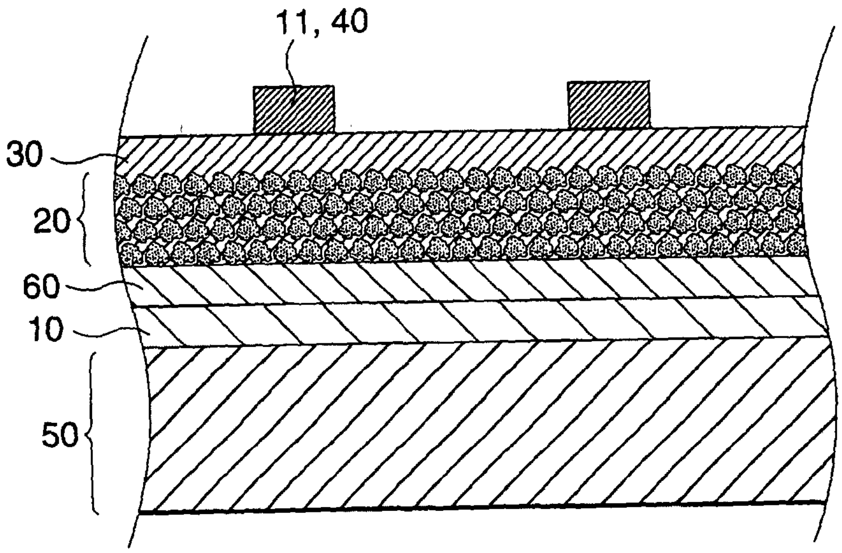


FIG. 10